Europäisches Patentamt

(19) European Patent Office

Office européen des brevets

(11) Publication number: **0 160 255**
**B1**

(12) **EUROPEAN PATENT SPECIFICATION**

(45) Date of publication of patent specification: **13.06.90**

(21) Application number: **85104809.0**

(22) Date of filing: **20.04.85**

(51) Int. Cl.⁵: **H 01 L 29/08, H 01 L 21/00,**
**H 01 L 21/28, H 01 L 21/31**

(54) **Field effect transistor device and method of making same.**

(30) Priority: **30.04.84 US 605460**

(43) Date of publication of application:
**06.11.85 Bulletin 85/45**

(45) Publication of the grant of the patent:
**13.06.90 Bulletin 90/24**

(84) Designated Contracting States:
**DE FR GB NL**

(56) References cited:
**EP-A-0 014 303**
**DE-A-2 726 003**
**US-A-4 318 216**

**IEEE TRANSACTIONS ON ELECTRON DEVICES,**
vol. ED-29, no. 4, April 1982, pages 590-596,
IEEE, New York, US; P.J. TSANG et al.:
"Fabrication of high-peformance LDDFET's with
oxide sidewall-spacer technology"

(73) Proprietor: **GENERAL ELECTRIC COMPANY**
**1 River Road**
**Schenectady New York 12305 (US)**

(72) Inventor: **Vosburgh, Kirby Gannett**
**900 St. David's Lane**
**Schenectady New York 12309 (US)**

(74) Representative: **Schüler, Horst, Dr. et al**
**Kaiserstrasse 69**
**D-6000 Frankfurt/Main 1 (DE)**

**Description**

The present invention relates in general to field effect transistor devices and in particular to a method of making field effect transistor devices which are of small dimensions yet which have high performance characteristics and are relatively easy to fabricate.

In the prior art (Fabrication of High-Performance LDDFET'S with Oxide Sidewall-Spacer Technology, IEEE Transactions on Electron Devices, Vol. ED-29, No. 4, April 1982), a field effect transistor is described comprising a substrate of silicon semiconductor material of one conductivity type having a planar surface on which a thin layer of insulating material is formed. A gate electrode is provided on the thin layer of insulating material and is utilized for the formation of a pair of shallow lightly doped regions of opposite conductivity type in the substrate on each side of the gate electrode. Next, an insulating spacer is provided on each side of the gate electrode overlying each of the shallow lightly doped regions. Thereafter, a pair of deep, heavily doped regions of opposite conductivity type are formed in the substrate not masked by the gate electrode and the insulating spacers to form the source and drain regions of the device. The device so formed is referred to as a lightly doped drain field effect transistor as the region of the drain adjacent the gate electrode is constituted of a shallow lightly doped region. In the prior art device described, the structure of the source is the same as the structure of the drain with a shallow lightly doped region extending between a more heavily doped region and the portion of the substrate underlying the gate. While it is desirable to provide a lightly doped drain region in order to improve the performance of the device, such as to increase the voltage at which drain-to-source punch through occurs, inclusion of such lightly doped regions in the source increases the source resistance and impairs the performance of the device. DE—A—27 26 003 discloses a method of making a field effect transistor.

An object of the present invention is to provide a simple method of making a field effect transistor of small dimensions which has a lightly doped drain and a heavily doped source.

This object is solved according to the invention by a method as defined in claim 1.

The novel features which are believed to be characteristic of the present invention are set forth with particularity in the appended claims. The invention itself, both as to its organization and method of operation, together with further objects and advantages thereof, may best be understood by reference to the following description taken in connection with the accompanying drawings wherein:

Figure 1 is a plan view of a field effect transistor in accordance with the present invention.

Figure 2 is a sectional view of a portion of the device of Figure 1 taken along section lines 2—2 showing the internal structure thereof.

Figure 3 is another sectional view of a portion of the device of Figure 1 taken along section lines 3—3 thereof also showing internal structure thereof.

Figures 4A—4G are schematic illustrations of vertical cross sections of a piece of semiconductor wafer in the process of fabrication of a field effect transistor in accordance with the present invention.

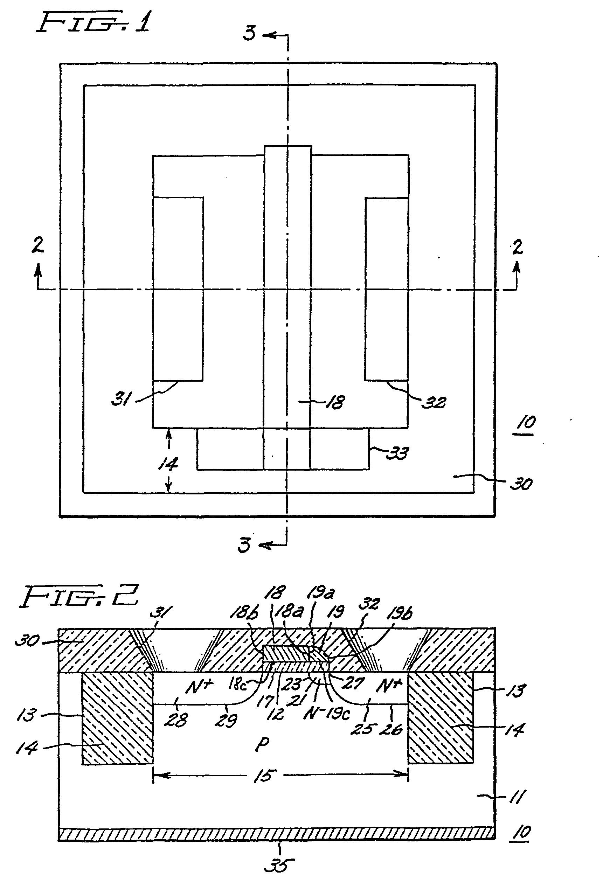

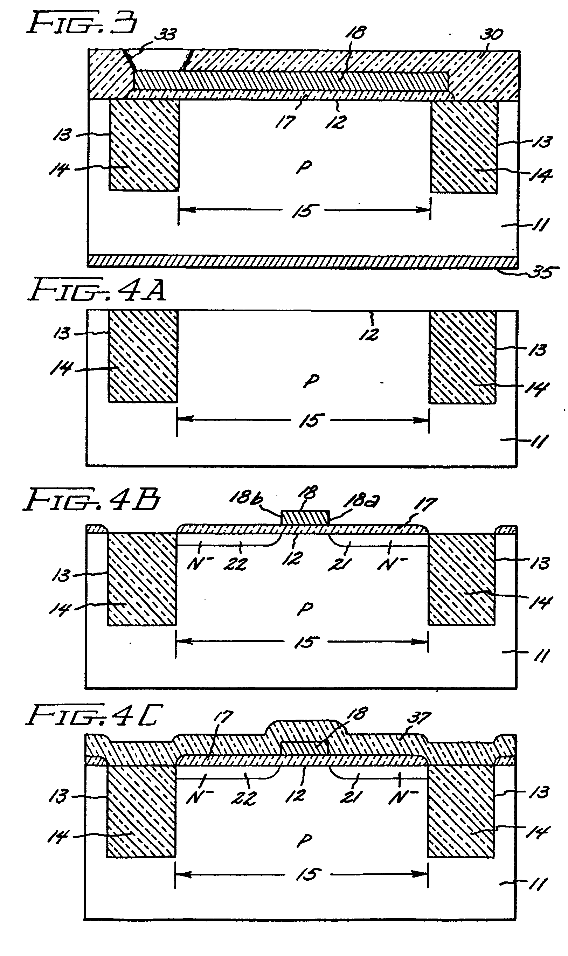

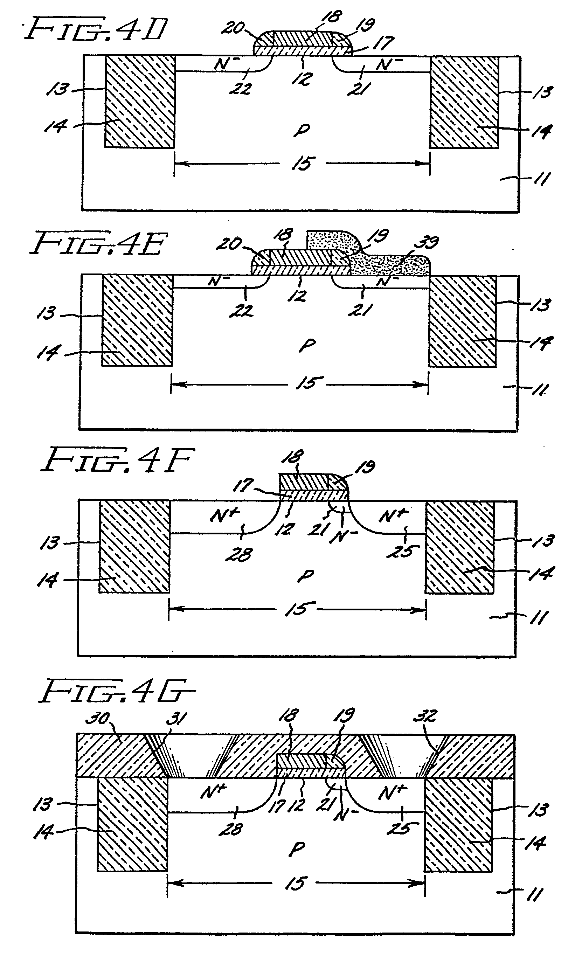

Referring now to Figures 1, 2 and 3, there is shown a portion of an integrated circuit including a field effect transistor 10 made in accordance with the present invention. The device includes a substrate of monocrystalline silicon semiconductor material of p-type conductivity and relatively high resistivity, for example, 2 ohm-cm. The substrate may be conveniently 0,25 mm (10 mils thick. A trench 13 about a $\mu$m (micron) wide and about a $\mu$m (micron) deep is formed in the planar surface 12 of the substrate 11 and filled with an insulating material 14 such as silicon dioxide surrounding an active region 15 of the substrate isolating this region from other such regions formed in the integrated circuit substrate. The sides of the active region 15 form a square in the plane of the major surface 12 of the substrate. A thin layer 17 of silicon dioxide is provided on the planar surface 12. A gate electrode 18 of polycrystalline silicon having sides 18a and 18b, and base 18c is provided on the insulating layer 17. An insulating spacer 19 having a first side 19a, a second side 19b and a base 19c is provided. First side 19a of the spacer 19 has a height equal to the height of the side 18a of the gating electrode 18 and is contiguous therewith. The base 19c is contiguous with the top surface of the thin insulating layer 17. A first lightly doped shallow region 21 of N-type conductivity is located adjacent the planar surface and underlying the base of the insulating spacer 19 forming a PN junction 23 with the substrate.

The insulating spacer 19 may be formed by covering the major surface of the substrate 11 with silicon dioxide, for example, by chemical vapor deposition and thereafter anisotropically etching the layer of silicon dioxide until all portions of the layer are completely removed except for a spacer 19 on side 18a of the electrode 18 and another spacer element 20 (not shown) on the other side 18b of the gate electrode 18. The spacer 19 is masked and spacer 20 on the other side of the gate electrode 18 is reactive ion etched using a gas such as trifluoromethane ($CHF_3$) which does not react or reacts minimally with the polycrystalline silicon material of the gate electrode 18 and which does react with silicon dioxide thereby selectively removing the insulating spacer 20. The thin layer 17 of silicon dioxide is formed by thermally growing silicon dioxide in the exposed portions of the planar surface. Gate electrode 18 is formed by depositing a layer of polycrystalline silicon overlying thin insulating layer 23 and thereafter patterning the layer by photolithographic masking and etching techniques well known in the art.

A heavily doped, deep region 25 of N-type conductivity is provided in the substrate adjacent the planar surface 12 and forms a PN junction 26 with the substrate. The PN junction 26 has an edge 27 in a planar surface 12 adjacent the bottom base 19c and the side 19b of the insulating spacer 19. An impurity or donor activator concentration in the region 25 is substantially greater than the donor activator concentration in the region 21. Another region 28 of N-type conductivity is provided in the substrate adjacent the major surface 12 and side 18b of the gating electrode 18 forming a PN junction 29 therewith. The PN junction 29 has an edge in the planar surface 12 and adjacent the side 18b of the gating electrode 18. The net impurity or donor concentration in the region 28 of N type conductivity is substantially greater than the donor concentration of the shallow, lightly doped region 21 and is substantially equal to the doping concentration in the region 25. The regions 25 and 28 of N type conductivity are formed by initially depositing by ion implantation a predetermined quantity of donor activators, such as arsenic of a dosage of about $10^{15}$ ions per $cm^2$, upon the major surface 12 of the substrate over these regions and thereafter activating the arsenic ions by heating at a suitable temperature and for a short time.

A thick layer 30 of silicon dioxide is chemically vapor deposited on the major surface of the substrate 11. Thereafter the thick layer 30 of silicon dioxide is patterned to form openings 31, 32 and 33 therein exposing the source region 28, the drain region 25 and the gate electrode 18. Thereafter a layer of aluminum is sputtered over the surface of the resultant structure into openings 31, 32 and 33. The layer of aluminum is then patterned to remove portions thereof leaving the conductive connections (not shown) making contact with the source region 28, the drain region 25 and the gate electrode 18, respectively. The device is then heated to a temperature of about 550°C for a time to bond the conductive connections of aluminum to the source region 28, the drain region 25 and the gate electrode 18. Subsequently, a conductive connection 35 of aluminum is formed on the opposite surface of the substrate.

Reference is now made to Figures 4A—4G which illustrate the manner of fabrication of the field effect transistor of Figures 1—3 in accordance with the present invention. Elements in Figures 4A—4G identical to elements of Figures 1—3 are identically designated. Initially, a wafer 11 of monocrystalline semiconductor material of relatively high resistivity, for example 2 ohms cm, having a convenient thickness, for example, 0,25 mm (10 mils), and a P-type conductivity is provided. The wafer may be of any convenient diameter on which a very large number of individual field effect transistors, such as shown in Figures 1—3, may be formed. Diagrams of Figures 4A—4G show the processing of the wafer as it affects the individual transistor on the wafer. After suitable cleaning of the surface of the wafer, a trench 13 about 1 µm (micron) wide and about 1 µm (micron) deep is etched into the silicon substrate utilizing photolithographic masking and etching techniques well known in the art to form an active region 15 of square outline of 3,5 µm (microns) on a side. Thereafter, the wafer is exposed to a mixture of silane and oxygen at a temperature of about 900°C for a sufficient period of time to fill the trenches 13 with silicon dioxide and also cover the exposed surfaces 12 of the wafer of silicon. The wafer is next planarized. To this end the wafer is covered with a suitable photoresist such as Hunt type 704 photoresist. Thereafter, the resist and the silicon dioxide are reactive ion etched in an atmosphere of trifluoromethane ($CHF_3$) and oxygen to produce the structure shown in Figure 4A in which an active region 15 is isolated from other active regions by the isolation regions 14 of silicon dioxide formed in the substrate 11.

In the next step of the process, shown in Figure 4B, a layer 17 of silicon dioxide, referred to as gate oxide, is thermally grown over the surface 12 of the substrate. A layer of polycrystalline silicon 0,5 µm (micron) thick is then deposited over the layer of gate oxide 17. The polycrystalline layer is suitably patterned using photolithographic masking and etching techniques well known in the art to form the gate electrode 18 one micron in length from side 18a to side 18b and 0,5 µm (micron) thick. Using the gate 18 as a mask arsenic ions of a dosage of $2 \times 10^{13}$ ions per $cm^2$ at 100 kilovolts are implanted and then flash annealed in the substrate 11 to form lightly doped shallow regions 21 and 22 of N-type conductivity having an activator concentration of about $10^{18}$ atoms per $cm^3$.

In the next step of the process, shown in Figure 4C, substrate 11 is covered with a layer 37 of chemically vapor deposited silicon dioxide 0,5 µm (micron) thick using silane and oxygen. Thereafter, the layer 35 of silicon dioxide is anistroopically etched in trifluoromethane ($CHF_3$), which etches silicon dioxide at a much more rapid rate than it etches silicon, to remove the silicon dioxide from the wafer until only spacer portions 19 and 20 remain as shown in Figure 4D. The height of the spacers 19 and 20 is about 0,5 µm (micron). The width of the bottom portions of the spacers 19 and 20 is also about 0,5 µm (micron).

In the next step of the process shown in Figure 4E, a layer of photoresist is deposited over the exposed surface of the wafer covering the gate electrode 18, the insulating spacers 19 and 20, and the exposed portions of the planar surface 12. The photoresist is a Shipley type AZ1470 positive photoresist 1 micron thick. The photoresist is patterned by photolithographic masking and etching techniques well known in the art to provide a mask 39 which covers a portion of the gate electrode 18, the insulating spacer 19, and a portion of the planar surface 12 as shown. The alignment of the mask 39 is not critical. The edge 39a of the mask 39 would be aligned to the center line of the gate electrode 18. A deviation of the alignment of edge 39a up to less than about one-half of the distance between edges 18a and 18b of the gate electrode 18 could be tolerated.

In the next step of the process, the exposed surface of the substrate is reactive ion etched in trifluoromethane ($CHF_3$) and argon to remove the spacer 20 and the portion of silicon dioxide layer 17 beneath spacer 20, to form the structure shown in Figure 4F. Thereafter, the photoresist pattern is removed. Regions adjacent the planar surface not masked by the gate electrode 18 or the insulating spacer 19 are implanted with arsenic ions of a dosage of $10^{15}$ atoms per $cm^2$ at 200 kilovolts. Therafter, the resultant structure is flash annealed at 1000°C for about 10 seconds to activate the ion implants to form the deep, heavily doped regions 25 and 28 in the substrate, as shown in Figure 4F. Heavily doped region 28 completely contains the lightly doped region 22 formed adjacent the planar surface 12 and also heavily doped region 25 contains a portion of the lightly doped region 21 formed adjacent the planar surface 12, as shown in Figure 4F.

The next step of the process is illustrated in Figure 4G. The surface of the wafer is covered with a layer 30 of silicon dioxide deposited thereon by chemical vapor deposition using silane and oxygen to a thickness of about 0,5 μm (micron). Thereafter, the layer 30 of silicon dioxide is patterned using photolithographic masking and etching techniques well known to those silled in the art to provide openings 31 and 32 to the source region 28 and the drain region 25 and to provide opening 33 (Fig. 1) to the gate electrode 18. At this point in the process, metal contacts (not shown) are provided to the source region 28, the drain region 25 and the gate electrode 18 of the transistor formed in the active region 15.

While the embodiments of the invention described above, N channel transistors were formed on P-type silicon substrates, P-channel transistors could as well have been formed on N-type conductivity substrates in a similar manner.

**Claims**

1. A method of making a field effect transistor comprising:

providing a substrate of silicon semiconductor material of one conductivity type having a planar surface,

forming a thin layer of insulating material on said planar surface,

forming a gate electrode having a pair of opposite sides on said thin layer of insulating material,

forming a first lightly doped shallow region of opposite conductivity type and a second lightly doped shallow region of opposite conductivity type in said substrate adjacent said planar surface, said first shallow region forming a first PN junction with said substrate, said first PN junction having an edge in said planar surface and adjacent one of said sides of said gating electrode, said first shallow region having a first concentration of activators, said second shallow region forming a second PN junction with said substrate, said second PN junction having an edge in said planar surface and adjacent the other of said sides of said gating electrodes, said second shallow region having a second concentration of activators equal to said first concentration of activators,

forming a first insulating spacer and a second insulating spacer, each including first and second opposed sides and a base,

the first side of said first spacer contiguous to one side of said gate electrode, the bottom base of said first spacer abutting the exposed surface of said thin layer of insulating material,

the first side of said second spacer contiguous to the other side of said gate. electrode, the bottom base of said second spacer abutting the exposed surface of said thin layer of insulating material,

removing said second spacer,

forming a first deep region of opposite conductivity type in said substrate adjacent said planar surface, said first deep region forming a third PN junction with said substrate, said third PN junction having an edge in said planar surface and adjacent said second side of said first insulating spacer, said first deep region having a third concentration of activators, said third concentration of activators being substantially greater than said first concentration of activators,

forming a second deep region of opposite conductivity type in said substrate adjacent said planar surface simultaneous with the formation of the first deep section,

said second deep region forming a fourth PN junction having an edge in said planar surface underlying said other side of said gate electrode, said second deep region having a fourth concentration of activators substantially equal to said third concentration of activators, said fourth deep region containing said second shallow region,

said first insulating spacer and said second insulating spacer are formed by depositing a layer of silicon dioxide of a predetermined thickness over said substrate and thereafter etching said layer of silicon dioxide anisotropically to the point of exposing the major surface of said substrate thereby forming said first insulating spacer and said second insulating spacer,

whereby a reactive ion etching mask is provided over a portion of said gate electrode including said one side thereof and over said first insulating spacer, and in which the exposed surface of said substrate is reactive ion etched using a gas which reactive ion etches silicon dioxide and which does not reactive ion etch the material of said gate electrode thereby selectively removing said second insulating spacer.

2. The method of claim 1 in which said gate electrode is constituted of heavily doped polycrystalline silicon.

3. The method of claim 1 in which said gas is trifluoromethane.

## Patentansprüche

1. Verfahren zum Herstellen eines Feldeffekt-Transistors, umfassend:

Schaffen eines Substrates aus Silizium-Halbleitermaterial eines Leitfähigkeitstyps mit einer planaren Oberfläche,

Bilden einer dünnen Schicht aus isolierendem Material auf der genannten planaren Oberfläche,

Bilden einer Gateelektrode mit einem Paar entgegengesetzter Seiten auf der genannten dünnen Schicht aus isolierendem Material,

Bilden eines ersten, wenig dotierten flachen Bereiches aus entgegengesetzten Leitfähighkeitstyp und eines zweiten, wenig dotierten flachen Bereiches entgegenesetzten Leitfähigkeitstyps in dem genannten Substrat benachbart der genannten planaren Oberfläche, wobei der erste flache Bereich einen ersten PN-Übergang mit dem Substrat bildet, der erste PN-Übergang eine Kante in der planaren Oberfläche und benachbart einer der Seiten der Gateelektrode hat, der erste flache Bereich eine erste Konzentration an Aktivatoren aufweist, der zweite flache Bereich einen zweiten PN-Übergang mit dem Substrat bildet, der zweite PN-Übergang eine Kante in der planaren Oberfläche und benachbart der anderen der Seiten der Gateelektrode aufweist, wobei der zweite flache Bereich eine zweite Konzentration an Aktivatoren enthält, die gleich der ersten Konzentration an Aktivatoren ist,

Bilden eines ersten isolierenden Distanzstückes und zweiten isolierenden Distanzstückes, wobei jedes erste und zweite gegenüberliegende Seiten und eine Basis einschließt,

die erste Seite des ersten Distanzstückes an eine Seite der Gateelektrode angrenzt, die Bodenbasis des ersten Distanzstückes an die freiliegende Oberfläche der dünnen Schicht aus isolierendem Material anstößt,

die erste Seite des zweiten Distanzstückes an die andere Seite der Gateelektrode angrenzt, die Bodenbasis des zweiten Distanzstückes an die freiliegende Oberfläche der dünnen Schicht aus isolierendem Material anstößt,

Entfernen des zweiten Distanzstückes,

Bilden eines ersten tiefen Bereiches entgegengesetzten Leitfähigkeitstyps in dem Substrat benachbart der planaren Oberfläche, wobei der erste tiefe Bereich einen dritten PN-Übergang mit dem Substrat bildet, der dritte PN-Übergang eine Kante in der planaren Oberfläche hat und benachbart der zweiten Seite des ersten isolierenden Distanzstückes, wobei der erste tiefe Bereich eine dritte Konzentration an Aktivatoren enthält, die wesentlich größer ist als die erste Konzentration an Aktivatoren,

Bilden eines zweiten tiefen Bereiches entgegengesetzten Leitfähigkeitstyps in dem Substrat, benachbart der planaren Oberfläche gleichzeitig mit der Bildung des ersten tiefen Bereiches, wobei der zweite tiefe Bereich einen vierten PN-Übergang mit einer Kante in der planaren Oberfläche bildet, die unter der anderen Seite der Gateelektrode liegt, und der zweite tiefe Bereich eine vierte Konzentration an Aktivatoren enthält, die im wesentlichen gleich der dritten Konzentration an Aktivatoren ist, der vierte tiefe Bereich den zweiten flachen Bereich enthält, das erste isolierende Distanzstück und das zweite isolierende Distanzstück durch Abscheiden einer Schicht aus Siliziumdioxid einer vorbestimmten Dicke über dem Substrat gebildet werden und danach die Schicht aus Siliziumdioxid anisotrop bis zu dem Punkt geätzt wird, daß die Hauptoberfläche des Substrates freigelegt wird, wodurch das erste isolierende Distanzstück und das zweite isolierende Distanzstück gebildet werden,

wobei eine Ätzmaske für reaktive Ionen über einem Teil der Gateelektrode einschließlich der genannten einen Seite davon und über dem ersten isolierenden Distanzstück geschaffen wird und man die freigelegte Oberfläche des Substrates mittels reaktiver Ionen ätzt, wobei man ein Gas benutzt, das Siliziumdioxid mittels reaktiver Ionen ätzt, das jedoch das Material der Gateelektrode nich mittels reaktiver Ionen ätzt und dadurch selektiv das zweite isolierende Distanzstück entfernt.

2. Verfahren nach Anspruch 1, wobei die Gateelektrode aus stark dotiertem polykristallinen Silizium gebildet wird.

3. Verfahren nach Anspruch 1, wobei das genannte Gas Trifluormethan ist.

## Revendications

1. Procédé de fabrication de transistor à effet de champ comprenant les étapes suivantes:

prévoir un substrat dont le matériau semiconducteur est du silicium d'un premier type de conductivité ayant une surface plane,

former une couche mince de matériau isolant sur ladite surface plane,

former une électrode de grille ayant deux côtés opposés sur ladite couche mince en matériau isolant,

former une première région faiblement dopée et peu profonde du type de conductivé opposé et une seconde région faiblement dopée et peu profonde du type de conductivité opposé dans le substrat de façon adjacente à ladite surface plane, ladite première région peu profonde formant une première jonction PN avec le substrat, cette première jonction PN ayant un bord dans ladite surace plane et adjacent à l'un desdits bords de l'électrode de grille, ladite première région peu profonde présentant une première concentration de dopants, ladite seconde région peu profonde formant une seconde jonction PN avec le substrat, ladite seconde jonction PN ayant un bord dans ladite surface plane et adjacent à l'autre desdits côtés de l'électrode de grille, ladite seconde région peu profonde présentant une seconde concentration de dopants égale à la première concentration de dopants,

former un premier espaceur isolant et un second espaceur isolant, chacun comprenant des premier et second côtés opposés et une base,

le premier côté du premier espaceur étant contigu à un côté de l'électrode de grille, le fond de la base du premier espaceur venant contre la surface exposée de ladite couche mince en matériau isolant,

le premier côté du second espaceur étant contigu à l'autre côté de l'électrode de grille, le fond de la base du second espaceur venant contre la surface exposée de ladite couche mince en matériau isolant,

enlever le second espaceur,

former une première région profonde du type de conductivité opposé dans le substrat adjacente à ladite surface plane, cette première région profonde formant une troisième jonction PN avec le substrat, cette troisième jonction PN ayant un bord dans ladite surface plane et étant adjacente audit second côté du premier espaceur isolant, ladite première région profonde présentant une troisième concentration de dopants, cette troisième concentration de dopants étant sensiblement supérieure à la première concentration de dopants,

former une seconde région profonde du type de conductivité opposé dans le substrat, adjacente à ladite surface plane simultanément avec la formation de la première région profonde, cette seconde région profonde formant une quatirème jonction PN ayant un bord dans ladite surface plane s'étendant sous ledit autre côté de l'électrode de grille, ladite seconde région profonde présentant une quatrième concentration de dopants substantiellement égale à la troisième concentration de dopants, la quatrième région profonde englobant la seconde région peu profonde,

le premier espaceur isolant et le second espaceur isolant étant formés par dépôt d'une couche de dioxyde de silicium d'une épaisseur prédéterminée sur le substrat et ensuite par gravure anisotrope de la couche de dioxyde de silicium effectuée jusqu'à laisser apparaître la surface principale du substrat de façon à former le premier espaceur isolant et le second espaceur isolant,

d'où il résulte qu'un masque de gravure ionique réactive est formé sur une partie de l'électrode de grille incluant ledit premier côté de celle-ci et sur le premier espaceur isolant, la surface exposée du substrat étant gravée par gravure ionique réactive en utilisant un gaz qui effectue une gravure ionique réactive du dioxyde de silicium et qui n'effectue pas de gravure ionique réactive du matériau de l'électrode de grille afin d'obtenir de la sorte l'enlèvement sélectif du second espaceur isolant.

2. Procédé selon la revendication 1, dans lequel l'électrode de grille est constituée de silicium polycristallin foretement dopé.

3. Procédé selon la revendication 1, dans lequel ledit gaz est du trifluorométhane.

FIG. 1

FIG. 2

*FIG.3*

*FIG.4A*

*FIG.4B*

*FIG.4C*

FIG.4D

FIG.4E

FIG.4F

FIG.4G